(19) Europäisches Patentamt

European Patent Office

Office européen des brevets

(11) **EP 0 998 031 A1**

(12) **DEMANDE DE BREVET EUROPEEN**

(43) Date de publication:
**03.05.2000 Bulletin 2000/18**

(51) Int. Cl.$^7$: **H03F 3/343**

(21) Numéro de dépôt: **99203407.4**

(22) Date de dépôt: **18.10.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **27.10.1998 FR 9813436**

(71) Demandeur:
**Koninklijke Philips Electronics N.V.
5621 BA Eindhoven (NL)**

(72) Inventeurs:
• **Chevallier, Gilles
75008 Paris (FR)**
• **Stickvoort, Edward
75008 Paris (FR)**

(74) Mandataire: **Chaffraix, Jean
Société Civile S.P.I.D.
156, Boulevard Haussmann
75008 Paris (FR)**

(54) **Amplificateur de courant à faible impédance d'entrée**

(57)    La présente invention concerne un amplificateur de courant A1 comportant deux transistors Q1 et Q2, dont les émetteurs sont reliés entre eux via une résistance R1.

Selon l'invention, l'entrée de l'amplificateur de courant est constituée par l'émetteur du premier transistor Q1, dont le collecteur est relié à la borne de sortie de l'amplificateur A1 via une deuxième résistance R2, d'une part, et à la première résistance R1 via le trajet de courant principal du deuxième transistor Q2, d'autre part.

L'amplificateur de courant A1 conforme à l'invention possède une structure simple, et présente une faible impédance d'entrée, ainsi qu'un gain aisément réglable.

Application : Amplificateurs faible bruit pour récepteurs de signaux radioélectriques.

FIG.2

Printed by Xerox (UK) Business Services
2.16.7 (HRS)/3.6

**Description**

La présente invention concerne un amplificateur de courant, muni d'une borne d'entrée et d'une borne de sortie, respectivement destinées à recevoir et à délivrer un courant d'entrée et de sortie, comprenant un premier et un deuxième transistor, chacun présentant une borne de polarisation, une borne de transfert et une borne de référence, les bornes de référence des premier et deuxième transistors étant reliées entre elles via une première résistance.

Parmi de multiples applications possibles, un tel amplificateur est souvent utilisé pour former un étage d'entrée, dit préamplificateur, au sein d'un amplificateur faible bruit destiné à amplifier un signal provenant d'un convertisseur de fréquence dans un appareil récepteur de signaux radioélectriques. Dans les amplificateurs faible bruit courants, le préamplificateur est constitué des premier et deuxième transistors montés en paire différentielle, la première résistance qui relie leurs bornes de référence formant alors une résistance de dégénérescence. Si, par exemple, les premier et deuxième transistors sont des transistors bipolaires, leurs bornes de polarisation, de transfert et de référence seront respectivement constituées par leurs bases, collecteurs et émetteurs. L'avantage que présente le préamplificateur connu est que son gain, défini comme le rapport entre la valeur de la composante alternative du courant de sortie et celle du courant d'entrée, et par conséquent le gain de l'ensemble de l'amplificateur faible bruit, peut être réglé aisément en ajustant la valeur de la première résistance. Toutefois, l'impédance d'entrée du préamplificateur connu est élevée, car sa borne d'entrée est constituée par la borne de polarisation de l'un des premier ou deuxième transistor. Conformément à la loi d'Ohm, cette forte impédance d'entrée induit pour le convertisseur de fréquence la nécessité de générer un signal présentant une excursion de tension importante, et provoque donc une forte consommation d'énergie, ce qui est un inconvénient important à une époque où l'un des grands axes de recherche et de développement dans l'industrie des circuits intégrés est précisément la diminution de la consommation énergétique desdits circuits. De plus, une forte impédance d'entrée du préamplificateur induit des contraintes dans le dimensionnement d'éléments passifs, tels des inductances ou des capacités, contenus dans le convertisseur de fréquence. En effet, les valeurs nominales de ces éléments devront être d'autant plus faibles que l'impédance d'entrée du préamplificateur sera grande. Or, les valeurs réelles de ces éléments passifs présenteront inévitablement par rapport à leurs valeurs nominales un écart dû aux imperfections liées au procédé de réalisation employé, écart dont l'influence sur le comportement du convertisseur de fréquence sera d'autant plus sensible que les valeurs nominales seront faibles. Une trop forte impédance d'entrée du préamplificateur risque donc d'introduire une part d'imprévisibilité dans le fonctionnement du convertisseur de fréquence, ce qui est à proscrire.

L'invention a pour but de remédier dans une large mesure à ces inconvénients en proposant un amplificateur de courant dont l'impédance d'entrée est faible en comparaison avec celle d'un préamplificateur connu, et dont le gain peut être ajusté aisément.

En effet, un amplificateur de courant conforme au paragraphe introductif est caractérisé selon l'invention en ce que, la borne de polarisation du premier transistor étant destinée à recevoir une tension de valeur prédéterminée, la borne de transfert du premier transistor est reliée à la borne de sortie de l'amplificateur via une deuxième résistance, la borne de référence du premier transistor formant la borne d'entrée de l'amplificateur, les bornes de polarisation et de transfert du deuxième transistor étant respectivement reliées à la borne de transfert du premier transistor et à une borne positive d'alimentation.

Dans cet amplificateur de courant, la borne d'entrée est constituée par la borne de référence du premier transistor, qui présente intrinsèquement une impédance plus faible que celle que présente la borne de polarisation. Par ailleurs, il sera démonté dans la suite de l'exposé que le gain d'un tel amplificateur peut être réglé aisément en ajustant les valeurs des première et deuxième résistances. Cette structure est remarquable par sa simplicité, qui permet de pallier les inconvénients décrits plus haut tout en présentant un faible coût de fabrication. De plus, une telle simplicité rend l'amplificateur particulièrement bien adapté à des applications où la valeur de la tension d'alimentation est faible.

Dans un mode de réalisation particulier de l'invention, les valeurs nominales des première et deuxième résistances sont sensiblement égales. Un tel choix permet d'obtenir un gain très important.

L'amplificateur présenté plus haut a pour fonction d'amplifier des signaux de courant de nature asymétrique. Or pour des raisons essentiellement liées à la nécessité de supprimer des signaux parasites pouvant apparaître lors de la conversion de fréquence, le convertisseur de fréquence présente souvent une structure symétrique, générant un signal de nature différentielle. Le préamplificateur connu, constitué par une paire différentielle dégénérée, est capable de traiter un tel signal. Ce préamplificateur présente alors une première et une deuxième bornes d'entrée, formées par les bornes de polarisation des transistors constituant la paire différentielle, et une première et une deuxième bornes de sortie, formées par les bornes de transfert desdits transistors. L'impédance d'entrée d'un tel préamplificateur, qui est l'impédance vue depuis les bornes de polarisation des transistors, est grande, ce qui induit des inconvénients similaires à ceux décrits plus haut.

Une variante de l'invention présente donc un amplificateur de courant destiné à l'amplification de signaux de nature différentielle, amplificateur dont l'impédance d'entrée est faible devant celle du préamplificateur connu, et dont le gain peut être ajusté aisément.

Un amplificateur de courant conforme à cette variante de l'invention est muni d'une première et d'une deuxième bornes d'entrée, destinées à recevoir un courant d'entrée de nature différentielle, et d'une première et d'une deuxième bornes de sortie, destinées à délivrer un courant de sortie de nature différentielle, comprenant un premier, un deuxième, un troisième et un quatrième transistors, chacun présentant une borne de polarisation, une borne de transfert et une borne de référence, les bornes de référence des premier et deuxième transistors étant reliées entre elles via une première résistance, les bornes de référence des troisième et quatrième transistors étant reliées entre elles via une deuxième résistance, les bornes de polarisation des premier et troisième transistors étant destinées à recevoir une tension de valeur prédéterminée, les bornes de transfert des premier et troisième transistors étant respectivement reliées aux bornes de référence des quatrième et deuxième transistors, dont les bornes de transfert sont respectivement reliées aux première et deuxième bornes de sortie de l'amplificateur via une troisième et une quatrième résistance, les bornes de référence des premier et troisième transistors formant les première et deuxième bornes d'entrée de l'amplificateur, les bornes de polarisation et de transfert des deuxième et quatrième transistors étant respectivement reliées aux bornes de transfert et de polarisation des quatrième et deuxième transistors.

Dans cet amplificateur de courant, les première et deuxième bornes d'entrée sont constituées par les bornes de référence des premier et troisième transistors, qui présentent intrinsèquement une impédance plus faible que celle que présentent leurs bornes de polarisation. Par ailleurs, il sera démontré dans la suite de l'exposé que le gain d'un tel amplificateur peut être réglé aisément en ajustant les valeurs des première, deuxième, troisième et quatrième résistances.

Dans un mode de réalisation particulier de l'invention, les valeurs nominales des première et deuxième résistances étant sensiblement égales à une première valeur nominale, celles des troisième et quatrième résistances sont sensiblement égales à une deuxième valeur nominale égale à la moitié de la première valeur nominale. Un tel choix permet d'obtenir un gain très important.

Si la présente invention peut être utilisée dans tous types d'applications nécessitant une amplification en courant, elle sera avantageusement mise en oeuvre pour amplifier des signaux représentatifs de signaux radioélectriques délivrés par un convertisseur de fréquence. L'invention concerne donc également un appareil récepteur de signaux radioélectriques, comportant :

. un système d'antenne et de filtrage, permettant la réception d'un signal radioélectrique dont la fréquence, dite fréquence radio, est sélectionnée au sein d'une gamme de fréquences donnée, et sa transformation en un signal électronique dit signal radio,

. un mélangeur, destiné à recevoir le signal radio et un signal provenant d'un oscillateur local dont la fréquence, dite d'oscillation, est réglable, et à délivrer un courant de sortie ayant une fréquence fixée et égale à la différence entre la fréquence radio et la fréquence d'oscillation, et

. un amplificateur faible bruit, destiné à recevoir le courant de sortie du mélangeur et à délivrer un signal amplifié représentatif du signal radioélectrique sélectionné,

appareil caractérisé en ce que l'amplificateur faible bruit comporte un étage d'entrée constitué par un amplificateur de courant tel que décrit plus haut.

L'invention sera mieux comprise à l'aide de la description suivante, faite à titre d'exemple non-limitatif et en regard des dessins annexés, dans lesquels :

- la figure 1 est un schéma fonctionnel partiel décrivant un appareil récepteur de signaux radioélectriques,
- la figure 2 est un schéma électrique décrivant un amplificateur de courant conforme à l'invention, et
- la figure 3 est un schéma électrique décrivant un amplificateur de courant conforme à une variante de l'invention.

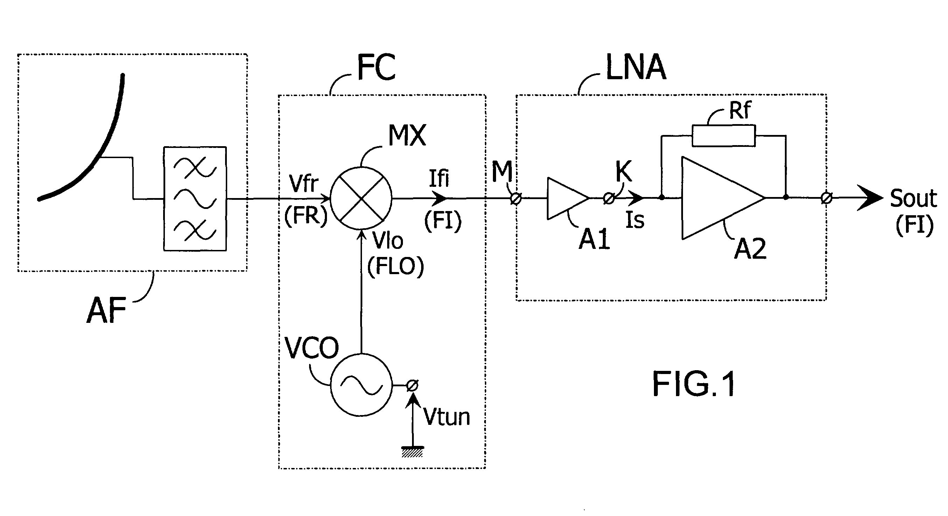

La figure 1 représente schématiquement un appareil récepteur de signaux radioélectriques, comportant un système d'antenne et de filtrage AF, permettant la réception d'un signal radioélectrique dont la fréquence FR, dite fréquence radio, est sélectionnée au sein d'une gamme de fréquences donnée, et sa transformation en un signal électronique Vfr dit signal radio. Cet appareil récepteur comporte en outre un convertisseur de fréquence FC, comprenant un oscillateur local VCO et un mélangeur MX, lequel est destiné à recevoir le signal radio Vfr et un signal Vlo provenant de l'oscillateur local VCO dont la fréquence FLO, dite d'oscillation, est réglable, et à délivrer un courant de sortie Ifi ayant une fréquence FI fixée et égale à la différence entre la fréquence radio FR et la fréquence d'oscillation FLO. Dans ce convertisseur de fréquence FC, le choix de la valeur fréquence d'oscillation FLO, effectué au moyen d'une tension de réglage Vtun, impose la valeur de la fréquence radio FR, puisque la fréquence intermédiaire FI est rendue fixe, par exemple à l'aide d'un système de filtrage non représenté sur la figure qui serait disposé en sortie du mélangeur MX. Le courant de sortie Ifi du mélangeur MX peut être de nature asymétrique ou différentielle, selon la nature de la structure choisie pour réaliser le convertisseur de fréquence FC.

L'appareil récepteur représenté à la figure 1 comporte de plus un amplificateur faible bruit LNA, destiné à recevoir le courant de sortie Ifi du mélangeur MX, et à délivrer un signal amplifié Sout représentatif du signal radioélectrique sélectionné. Cet amplificateur LNA comprend un étage d'entrée, dit préamplificateur, constitué par un premier amplificateur A1, et un deuxième amplificateur A2, lequel est muni, dans ce mode de réalisation, d'une résistance de rebouclage Rf destinée à améliorer la linéarité de l'amplification opérée par le deuxième amplificateur A2. La valeur de cette résistance Rf est déterminée en fonction des valeurs des composants constituant le deuxième amplificateur A2. Il n'est donc pas souhaitable de jouer sur la valeur de la résistance de rebouclage Rf pour ajuster la valeur du gain de l'amplificateur faible bruit LNA, car la linéarité de l'amplification opérée par le deuxième amplificateur A2 pourrait s'en trouver détériorée. Il est préférable de choisir, pour réaliser le préamplificateur A1, une structure dont le gain peut être ajusté aisément De plus, l'impédance d'entrée de ce préamplificateur A1 doit être faible, dans le double but de minimiser la consommation d'énergie effectuée par le mélangeur MX, et d'assurer l'intégrité du fonctionnement du convertisseur de fréquence FC.

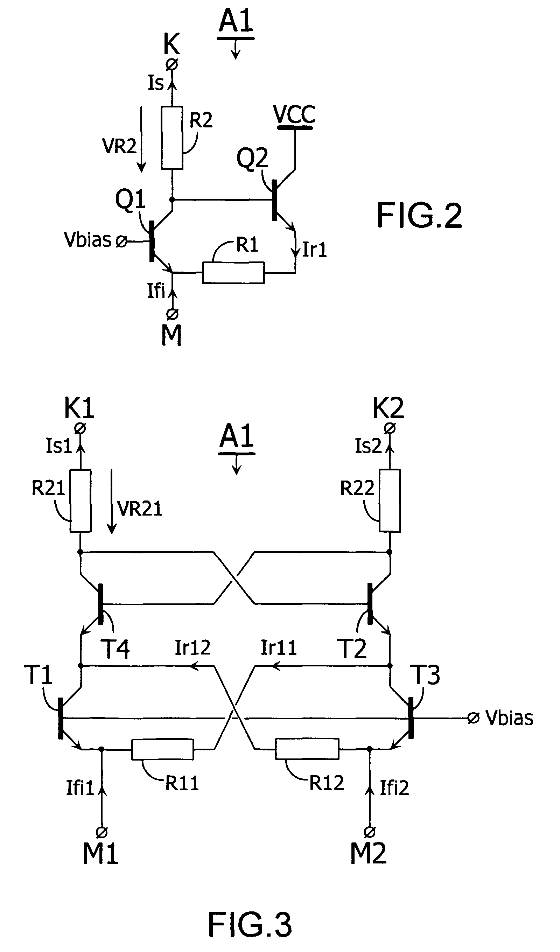

La figure 2 représente un amplificateur A1 conforme à l'invention qui répond aux exigences citées ci-dessus. Cet amplificateur de courant A1 est muni d'une borne d'entrée M et d'une borne de sortie K, respectivement destinées à recevoir et à délivrer un courant d'entrée Ifi et de sortie Is. L'amplificateur A1 comprend un premier et un deuxième transistor Q1 et Q2, chacun présentant une borne de polarisation, une borne de transfert et une borne de référence. Les premier et deuxième transistors Q1 et Q2 étant de type bipolaire dans ce mode de réalisation, leurs bornes de polarisation, de transfert et de référence sont respectivement constituées par leurs bases, collecteurs et émetteurs. Si, dans un autre mode de réalisation, les premier et deuxième transistors Q1 et Q2 avaient été des transistors de type MOS, leurs bornes de polarisation, de transfert et de référence auraient été respectivement constituées par leurs grilles, drains et source. Les bornes de référence des premier et deuxième transistors Q1 et Q2 sont reliées entre elles via une première résistance R1. La borne de polarisation du premier transistor Q1 est destinée à recevoir une tension Vbias de valeur prédéterminée, la borne de transfert du premier transistor Q1 est reliée à la borne de sortie K de l'amplificateur A1 via une deuxième résistance R2. La borne de référence du premier transistor Q1 forme la borne d'entrée M de l'amplificateur A1, les bornes de polarisation et de transfert du deuxième transistor Q2 étant respectivement reliées à la borne de transfert du premier transistor Q1 et à une borne positive d'alimentation VCC.

L'analyse du fonctionnement dynamique de cet amplificateur de courant A1, dans l'hypothèse dite des petits signaux alternatifs bien connue de l'homme du métier, peut être faite comme suit : la loi des noeuds appliquée à la borne de transfert du premier transistor Q1 permet d'écrire que $Is=Ifi+Ir1$ . D'autre part, lorsque l'amplificateur A1 est intégré dans l'amplificateur faible bruit décrit plus haut, on peut considérer que, en fonctionnement dynamique, la borne de sortie K est reliée à la masse du circuit. Ceci permet d'écrire que la tension VR2 présente aux bornes de la résistance R2 est égale à $R2.Is$, ou encore $VR2=R2(Ifi+Ir1)$ . Enfin, la composante alternative de la tension présente à la borne de transfert du premier transistor Q1 se trouve répercutée aux bornes de la première résistance R1, puisque les tensions continues sont inopérantes dans l'hypothèse des petits signaux alternatifs. On a donc $VR2=R1.Ir1$ , ce qui donne $R2.Ifi+R2.Ir1=R1.Ir1$ , ou encore $Ir1=Ifi.R2/(R1-R2)$ . En reportant cette expression dans celle obtenue par la loi des noeuds, on obtient aisément l'expression de la composante alternative du courant de sortie : $Is=Ifi.(1+R2/(R1-R2))$ . Le gain G de l'amplificateur de courant A1 s'exprime donc sous la forme $G=(1+R2/(R1-R2))$ , et il apparaît clairement que sa valeur peut être aisément réglée en ajustant les valeurs des première et deuxième résistances R1 et R2. En particulier, si l'on choisit pour lesdites résistances R1 et R2 des valeurs nominales sensiblement égales, la différence R1-R2 devient très faible et la valeur du gain G devient alors très grande.

La figure 3 présente un amplificateur A1 conforme à une variante de l'invention, constitué de deux amplificateurs tels que décrits ci-dessus, imbriqués de manière à présenter une structure symétrique. Cet amplificateur A1 est destiné à amplifier un courant de nature différentielle, tout en présentant une impédance d'entrée faible par rapport à celle d'une paire différentielle, et un gain aisément réglable. L'utilisation d'une telle variante de l'invention est particulièrement avantageuse au sein d'un appareil récepteur de signaux radioélectriques comportant un convertisseur de fréquence au sein duquel le mélangeur est doté d'une structure symétrique, pour des raisons essentiellement liées à la nécessité de supprimer des signaux parasites pouvant apparaître lors de la conversion de fréquence, et génère alors un courant différentiel. Cet amplificateur A1 est muni d'une première et d'une deuxième bornes d'entrée M1 et M2, formant une entrée différentielle destinée à recevoir un courant d'entrée de nature différentielle (Ifi1, Ifi2), les composantes alternatives des courants Ifi1 et Ifi2 étant les opposées l'une de l'autre. L'amplificateur A1 est muni d'une première et d'une deuxième bornes de sortie, K1 et K2, formant une sortie différentielle destinée à délivrer un courant de sortie de nature différentielle (Is1, Is2), les composantes alternatives des courants Is1 et Is2 étant les opposées l'une de l'autre. L'amplificateur A1 comprend un premier, un deuxième, un troisième et un quatrième transistors T1, T2, T3 et T4, chacun présentant une borne de polarisation, une borne de transfert et une borne de référence.

Lesdits transistors T1, T2, T3 et T4 étant de type bipolaire dans ce mode de réalisation, leurs bornes de polarisation, de transfert et de référence sont respectivement constituées par leurs bases, collecteurs et émetteurs. Les bornes de référence des premier et deuxième transistors T1 et T2 sont reliées entre elles via une première résistance R11, les bornes de référence des troisième et quatrième transistors T3 et T4 sont reliées entre elles via une deuxième résistance R12. Les bornes de polarisation des premier et troisième transistors T1 et T3 sont destinées à recevoir une tension Vbias de valeur prédéterminée. Les bornes de transfert des premier et troisième transistors T1 et T3 sont respectivement reliées aux bornes de référence des quatrième et deuxième transistors T4 et T2, dont les bornes de transfert sont respectivement reliées aux première et deuxième bornes de sortie K1 et K2 de l'amplificateur A1 via une troisième et une quatrième résistance R21 et R22. Les bornes de référence des premier et troisième transistors T1 et T3 forment les première et deuxième bornes d'entrée M1 et M2 de l'amplificateur A1. Les bornes de polarisation et de transfert des deuxième et quatrième transistors T2 et T4 sont respectivement reliées aux bornes de transfert et de polarisation des quatrième et deuxième transistors T4 et T2.

L'analyse du fonctionnement dynamique de cet amplificateur de courant A1, dans l'hypothèse dite des petits signaux alternatifs bien connue de l'homme du métier, peut être faite comme suit : la loi des noeuds appliquée à la borne de transfert du quatrième transistor T4 permet d'écrire que $Is1=Ifi1+Ir11+Ir12$. D'autre part, lorsque l'amplificateur A1 est intégré dans l'amplificateur faible bruit décrit plus haut, on peut considérer que, en fonctionnement dynamique, la borne de sortie K est reliée à la masse du circuit. Ceci permet d'écrire que la tension VR21 présente aux bornes de la troisième résistance R21 est égale à $R21.Is$, ou encore $VR21=R21(Ifi1+Ir11+Ir12)$. De plus, la composante alternative de la tension présente à la borne de transfert du quatrième transistor T4 se trouve répercutée aux bornes de la première résistance R11, puisque les tensions continues sont inopérantes dans l'hypothèse des petits signaux alternatifs. On a donc $VR21=R11.Ir11$, ce qui donne $R21.Ifi1+R21.Ir11+R21.Ir12=R11.Ir11$. Dans un souci de symétrie, on choisira les valeurs nominales des première et deuxième résistances R11 et R12 sensiblement égales à une première valeur nominale R1, et les valeurs nominales des troisième et quatrième résistances R21 et R22 sensiblement égales à une deuxième valeur nominale R2, ce qui implique que les courants Ir11 et Ir12 sont égaux. Cette symétrie permet d'écrire que $Is1=Ifi1+2.Ir11$, ce qui entraîne que $R2.Ifi1+2.R2.Ir11=R1.Ir11$, soit encore $Ir11=Ifi1.R2/(R1-2.R2)$. En reportant cette expression dans celle obtenue par la loi des noeuds, on obtient aisément l'expression de la composante alternative du courant de sortie : $Is=Ifi.(1+2.R2/(R1-2.R2))$. Le gain G de l'amplificateur de courant A1 s'exprime donc sous la forme $G=(1+2.R2/(R1-2.R2))$, et il apparaît clairement que sa valeur peut être aisément réglée en ajustant les première et deuxième valeurs nominales R1 et R2. En particulier, si l'on ajuste ces valeurs de sorte que la deuxième valeur nominale R2 soit sensiblement égale à la moitié de la première valeur nominale R1, la différence $R1-2.R2$ devient très faible et la valeur du gain G devient alors très grande.

## Revendications

**1.** Amplificateur de courant, muni d'une borne d'entrée et d'une borne de sortie, respectivement destinées à recevoir et à délivrer un courant d'entrée et de sortie, comprenant un premier et un deuxième transistor, chacun présentant une borne de polarisation, une borne de transfert et une borne de référence, les bornes de référence des premier et deuxième transistors étant reliées entre elles via une première résistance,

amplificateur de courant caractérisé en ce que, la borne de polarisation du premier transistor étant destinée à recevoir une tension de valeur prédéterminée, la borne de transfert du premier transistor est reliée à la borne de sortie de l'amplificateur via une deuxième résistance, la borne de référence du premier transistor formant la borne d'entrée de l'amplificateur, les bornes de polarisation et de transfert du deuxième transistor étant respectivement reliées à la borne de transfert du premier transistor et à une borne positive d'alimentation.

**2.** Amplificateur de courant selon la revendication 1, caractérisé en ce que les valeurs nominales des première et deuxième résistances sont sensiblement égales.

**3.** Amplificateur de courant, muni d'une première et d'une deuxième bornes d'entrée, destinées à recevoir un courant d'entrée de nature différentielle, et d'une première et d'une deuxième bornes de sortie, destinées à délivrer un courant de sortie de nature différentielle, comprenant un premier, un deuxième, un troisième et un quatrième transistors, chacun présentant une borne de polarisation, une borne de transfert et une borne de référence, les bornes de référence des premier et deuxième transistors étant reliées entre elles via une première résistance, les bornes de référence des troisième et quatrième transistors étant reliées entre elles via une deuxième résistance, les bornes de polarisation des premier et troisième transistors étant destinées à recevoir une tension de valeur prédéterminée, les bornes de transfert des premier et troisième transistors étant respectivement reliées aux bornes de référence des quatrième et deuxième transistors, dont les bornes de transfert sont respectivement reliées aux première et deuxième bornes de sortie de l'amplificateur via une troisième et une quatrième résistance, les bornes de référence des premier et troisième transistors formant les première et deuxième bornes d'entrée de l'amplificateur, les bornes de polarisation et de transfert des deuxième et quatrième transistors étant respectivement reliées aux bornes de transfert et de polarisation des quatrième et deuxième transistors.

4. Amplificateur de courant selon la revendication 3, caractérisé en ce que, les valeurs nominales des première et deuxième résistances étant sensiblement égales à une première valeur nominale, celles des troisième et quatrième résistances sont sensiblement égales à une deuxième valeur nominale égale à la moitié de la première valeur nominale.

5. Appareil récepteur de signaux radioélectriques, comportant :

. un système d'antenne et de filtrage, permettant la réception d'un signal radioélectrique dont la fréquence, dite fréquence radio, est sélectionnée au sein d'une gamme de fréquences donnée, et sa transformation en un signal électronique dit signal radio,
. un mélangeur, destiné à recevoir le signal radio et un signal provenant d'un oscillateur local dont la fréquence, dite d'oscillation, est réglable, et à délivrer un courant de sortie ayant une fréquence fixée et égale à la différence entre la fréquence radio et la fréquence d'oscillation, et
. un amplificateur faible bruit, destiné à recevoir le courant de sortie du mélangeur et à délivrer un signal amplifié représentatif du signal radioélectrique sélectionné,

appareil caractérisé en ce que l'amplificateur faible bruit comporte un étage d'entrée constitué par un amplificateur de courant conforme à l'une des revendications 1 ou 3.

FIG.1

FIG.2

FIG.3

# EP 0 998 031 A1

| | | |
|---|---|---|
| Office européen des brevets | **RAPPORT DE RECHERCHE EUROPEENNE** | Numéro de la demande<br>EP 99 20 3407 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | DE 20 35 969 A (SIEMENS AG)<br>3 février 1972 (1972-02-03)<br>* le document en entier * | 1,2 | H03F3/343 |
| A | EP 0 729 225 A (TELEFUNKEN MICROELECTRON)<br>28 août 1996 (1996-08-28)<br>* le document en entier * | 1,2 | |
| A | GB 2 148 642 A (TELEFUNKEN ELECTRONIC GMBH) 30 mai 1985 (1985-05-30)<br>* le document en entier * | 1 | |
| A | US 3 733 559 A (THORPE L)<br>15 mai 1973 (1973-05-15)<br>* le document en entier * | 3 | |

| | |
|---|---|
| | **DOMAINES TECHNIQUES RECHERCHES (Int.Cl.7)**<br><br>H03F |

Le présent rapport a été établi pour toutes les revendications

| Lieu de la recherche | Date d'achèvement de la recherche | Examinateur |
|---|---|---|
| LA HAYE | 3 février 2000 | Tyberghien, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)